# EUROPÄISCHE PATENTSCHRIFT

(11) **EP 1 582 832 B1**
(45) Veröffentlichungstag und Bekanntmachung des Hinweises auf die Patenterteilung: **18.04.2007**
(21) Anmeldenummer: 04006113.7
(22) Anmeldetag: 15.03.2004
(51) Int. Cl.: F27B 5/00, F27B 9/04, F27B 9/30, C03C 17/00, C23C 14/00

(54) **Vakuumbehandlungsanlage mit Umsetzbarem Wartungsventil**
Vacuum treatment apparatus having detachable valve
Système de traitement sous vide avec vanne détachable

(43) Veröffentlichungstag der Anmeldung: 05.10.2005
(73) Patentinhaber: Applied Materials GmbH & Co. KG, 63755 Alzenau (DE)
(72) Erfinder: Richert, Holger, 63486 Bruchköbel (DE); Sauer, Andreas, 63762 Grossostheim (DE); Hattendorf, Guido, 63636 Brachttal (DE)
(74) Vertreter: GROSSE BOCKHORNI SCHUMACHER

(56) Entgegenhaltungen:
- EP-A- 0 665 193
- EP-A- 0 869 199
- DE-A- 4 408 947
- US-A- 3 226 102

## Beschreibung

Die vorliegende Erfindung betrifft eine Vakuumbehandlungsanlage nach dem Oberbegriff des Anspruchs 1.

Vakuumbehandlungsanlagen und hier insbesondere Glasbeschichtungsanlagen, bei denen die zu beschichtenden Glassubstrate kontinuierlich durch eine Vielzahl von nebeneinander angeordneten Kammern oder Kammerbereichen (Kompartments) hindurchgeführt werden und in den Kompartments unterschiedlichen Prozessen ausgesetzt werden, werden vielfältig eingesetzt.

Um die in den verschiedenen Kammerbereichen (Kompartments) durchgeführten Prozesse nicht gegenseitig zu stören, sind die Kompartments oder Bereiche mit mehreren Kompartments üblicherweise vakuumdicht gegeneinander abgetrennt und werden getrennt voneinander abgepumpt, wobei lediglich sogenannte Schlitzschleusen zwischen den Kompartments bzw. Kammern vorgesehen sind, um die zu beschichtenden Substrate von einem Kompartment in das andere bewegen zu können. Durch die Schlitzschleusen, die im wesentlichen durch eine schlitzförmige Öffnung zwischen den Kompartments bzw. Kammern gebildet sind, ist es einerseits möglich, die plattenförmigen Glassubstrate auf entsprechenden Fördereinrichtungen, wie z. B. Rollenförderer, ohne weitere Betätigung von Ventilen oder Schleusen kontinuierlich hindurchzubewegen und andererseits zu vermeiden, dass ein unerwünschter Austausch an Atmosphäre zwischen benachbarten Kompartments stattfindet.

Allerdings werden üblicherweise zwischen bestimmten Kompartments oder Kammern zusätzliche Trennventile vorgesehen, die eine absolute gasdichte oder vakuumdichte Abtrennung der Kompartments oder Kammern ermöglichen, um bei Wartungsarbeiten oder beim Wechsel von Beschichtungskathoden nicht die gesamte Beschichtungsanlage fluten zu müssen, sondern lediglich den für die Wartungs- oder Austauscharbeiten betroffenen Bereich.

Aufgrund der erforderlichen vakuumdichten Anordnung dieser Trennventile und der notwendigen Abstimmung mit den in den Kompartments vorgesehenen Prozess- oder Messwerkzeugen, wird die Lage und Anordnung der Trennventile beim Bau einer Glasbeschichtungsanlage vorbestimmt und festgelegt, so dass genau definiert ist, welche Bereiche anschließend über Trennventile gegenseitig absperrbar sind.

Aufgabe der vorliegenden Erfindung ist es, eine Vakuumbehandlungsanlage und insbesondere eine kontinuierlich arbeitende Glasbeschichtungsanlage bereitzustellen, die eine effektive und variable Nutzung der Glasbeschichtungsanlage sowie Herstellung dieser Anlage ermöglicht.

Diese Aufgabe wird gelöst durch eine Vakuumbehandlungsanlage mit den Merkmalen des Anspruchs 1, wobei vorteilhafte Ausgestaltungen Gegenstand der abhängigen Ansprüche sind.

Die Erfinder haben erkannt, dass Glasbeschichtungsanlagen, bei denen die Trennventile fest und unveränderbar beim Bau der Glasbeschichtungsanlage festgelegt werden, erhebliche Nachteile im Hinblick auf eine variable und effektive Nutzung aufweisen, da bei einer Änderung der Beschichtungsprozesse, z.B. infolge einer Abänderung der Schichtenfolge, möglicherweise eine unterschiedliche Belegung der Kompartments mit veränderten Beschichtungs- oder Prozesswerkzeugen erfolgen muss und damit die vorgegebene Anordnung der Trennventile nicht mehr für die dem veränderten Beschichtungsprozess angepassten Wartungsaufgaben passend ist.

Nach Maßgabe der Erfindung kann dieses Problem dadurch gelöst werden, dass die Trennventile lösbar in den verschiedenen Kammern oder Kammerbereichen befestigt werden, so dass die Trennventile bei Bedarf jederzeit versetzt oder umgeordnet werden können, um andere abtrennbare Bereiche in der Glasbeschichtungsanlage oder Vakuumbehandlungsanlage zu schaffen.

Insbesondere ist es nicht erforderlich, die Trennventile bzw. Ventileinrichtungen in gesonderten Gehäusen zwischen benachbarten Kammern anzuordnen, was zudem einen erheblichen Platzbedarf verursacht, sondern die Ventileinrichtungen werden vorzugsweise an der Innenseite der Kammer und/oder Trennwand befestigt, so dass eine beabstandete Anordnung benachbarter Kammern durch das Vorsehen von zwischengeschalteten Trennventilen vermieden wird.

Vorteilhaft sind hierbei sowohl die Ventileinrichtung als auch die Kammern so ausgebildet, dass die Ventileinrichtung ohne, d.h. ohne wesentliche Veränderungen an den Kammer- und/oder Trennwänden, an denen sie angeordnet wird, an diesen befestigt oder von diesen wieder abgenommen werden kann.

Vorteilhaft ist auch, wenn die Ventileinrichtung einerseits und die Kammer mit den darin angeordneten Prozesswerkzeugen und Transporteinrichtungen für die Substrate andererseits so aufeinander abgestimmt sind, dass die Ventileinrichtung unabhängig von den Prozesswerkzeugen und den Transporteinrichtungen in der Kammer bzw. an den Kammer- oder Trennwänden angeordnet werden kann. Dies wird insbesondere dann erreicht, wenn das Trennventil bzw. die Ventileinrichtung in ihren Dimensionen besonders klein und insbesondere besonders flach ausgebildet wird, so dass Kollisionen mit Prozesswerkzeugen und/oder Transporteinrichtungen vermieden werden.

Durch die Anordnung der lösbar befestigten Ventileinrichtung (Trennventil) in der Kammer ist bei der Anbringung oder Entfernung eines Trennventils somit im wesentlichen keine Veränderung der Kammer oder der Anordnung der Prozesswerkzeuge und der Transporteinrichtung in der Kammer zumindest nach erfolgtem Ein- oder Ausbau sowie eine meist ohnehin nicht vornehmbare Änderung der Lage der Kammern zueinander erforderlich. Auch das zusätzliche Vorsehen von gesonderten Trennventilgehäusen zwischen den Kammern entfällt hiermit.

Vorzugsweise weist die Ventileinrichtung ein Gehäuse auf, mit dem die Ventileinrichtung in vakuum- bzw. gasdichter Weise in der Kammer bzw. an der Kammer- oder Kompartmentwand angeordnet werden kann. Vakuumdicht heißt hierbei, dass insbesondere in radialer Richtung ausgehend von der Durchgangsöffnung für die Substrate an den Verbindungen Dichtungen vorgesehen sind, um bei geschlossener Ventilklappe eine vakuum- bzw. gasdichte Abtrennung des Kompartments bzw. des Kammerbereichs zu gewährleisten, also die Dichtheit der Trenn- oder Kammerwand auch über das Ventilgehäuse zu garantieren.

Vorzugsweise ist die Ventileinrichtung bzw. das Trennventil mit seinem Gehäuse über eine Halterung im Bereich der Schlitzschleusen an den Kammer- bzw. Trennwänden angeordnet, wobei die Halterung vorzugsweise in Form einer Klammer, die benachbarte Kammerwand oder die Trennwand um die Durchgangsöffnung herum umgreift. Damit ist gewährleistet, dass eine besonders einfache Anbringung ohne große Veränderungen an den Kammern oder Kompartments ermöglicht wird.

Vorzugsweise weisen die Halterung und die Trenn- bzw. Kammerwände komplementäre Stufen auf, über die sie ineinandergreifen, um hier eine besonders dichte Verbindung zu schaffen.

Bevorzugt ist das Trennventil, welches als Schieber- oder Klappenventil, also mit einer Ventilklappe mit Dreh- oder Translationsbewegung beim Schließvorgang, vorgesehen sein kann, als Schieberventil ausgebildet, welches beidseitig, also in beiden Richtungen die Öffnung verschließen kann, so dass die Ventileinrichtung sowohl auf der einen als auch auf der anderen Seite bei Vakuum- oder Atmosphärenbedingungen eingesetzt werden kann. Entsprechend kann die Ventileinrichtung auch variabel in Transportrichtung gesehen vor oder hinter einer Kammer- oder Trennwand angeordnet werden.

Weitere Einzelheiten und Vorteile des Gegenstands der Erfindung gehen aus den Zeichnungen eines Ausführungsbeispiels und der sich im Folgenden anschließenden eingehenden Beschreibung hervor.
- Figur 1: zeigt schematisch einen Längsschnitt durch eine Glasbeschichtungsanlage mit mehreren Kammern und Kammerbereichen (Kompartments),
- Figur 2: zeigt schematisch einen Querschnitt durch das Schieberventil gemäß der Erfindung in der Arbeitsstellung der Schieberplatte,
- Figur 3: zeigt einen vergleichbaren Querschnitt in der Ruhestellung der Schieberplatte.

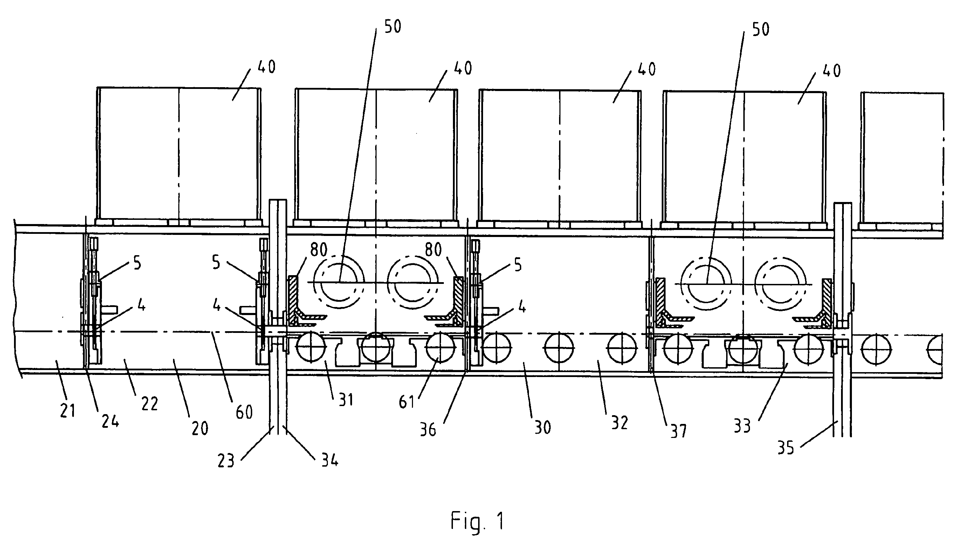

Fig. 1 zeigt in einer Querschnittsansicht einen Teil einer Glasbeschichtungsanlage mit zwei benachbarten Kammern 20 und 30, die wiederum in unterschiedliche Kompartments 21, 22, 31, 32 und 33 unterteilt sind.

In Durchgangsrichtung der Substrate ist die Kammer 30 durch die Kammerwände 34 und 35, die als Kammerflansche ausgeführt sind, begrenzt, während die Kammer 20 benachbart zur Kammerwand 34 der Kammer 30 die Kammerwand 23 in Form eines Kammerflansches aufweist.

Die Kompartments 21, 22, 31, 32 und 33 sind innerhalb der Kammern 20, 30 durch Trennwände 24, 36 und 37 voneinander getrennt, und zwar jeweils bis auf die Öffnungen 4, die als Schlitzschleusen zur Durchführung der Substrate dienen, vakuumdicht.

An der Oberseite der Kammern 20 und 30 sind Pumpeinrichtungen 40 vorgesehen, die zum Abpumpen der Kompartments 21, 22 und 31 bis 33 dienen, um die Vakuumbedingungen für die Beschichtung einzustellen.

In den Kompartments, die vom Kompartment- bzw. Kammeraufbau im wesentlichen identisch ausgeführt sind, können unterschiedlichste Prozesse oder Arbeitsschritte durchgeführt werden, wie z.B. Beschichtungsprozesse, Messungen o.dgl., oder sie können als Gastrennstufen zwischen Kompartments mit unterschiedlichen Beschichtungswerkzeugen eingesetzt werden. Beispielsweise ist das Kompartment 22 als Messkompartment ausgebildet und die Kompartments 31 und 33 als Beschichtungskompartments mit drehbaren Dual-Magnetron-Kathoden 50, während das Kompartment 30 beispielsweise als Pumpkompartment ausgeführt ist.

Das Substrat bewegt sich entlang der gestrichelten Linie 60 auf einer Transporteinrichtung mit vorzugsweise einer Vielzahl von Transportrollen 61 durch die einzelnen Kompartments, wobei der Übergang von einem Kompartment zum anderen Kompartment bzw. zwischen den Kammern durch die Öffnungen 4 in Form von Schlitzschleusen erfolgt.

Insbesondere an den Kompartments 31 und 33, die als Beschichtungskompartments ausgebildet sind, können Blendenvorrichtung 80 an den Trennwänden 36, 37 und/oder Kammerwänden 34, 35 vorgesehen sein.

Die verschiedenen Kammerbereiche (Kompartments) oder Kammern können durch die variable Anordnung von Trennventilen 5 vakuumdicht abgeschlossen werden, um die Glasbeschichtungsanlage nur teilweise bei Wartungsarbeiten fluten zu können. So kann beispielsweise das Kompartment 31 mit den Trennventilen 5 an der Trennwand 36 einerseits und den Kammerwänden 23 und 34 andererseits vakuumdicht abgeschlossen werden, um beispielsweise darin die Kathoden 50 zu wechseln, ohne die übrige Anlage belüften zu müssen.

Da die Trennventile 5 erfindungsgemäß lösbar an den Trennwänden 24, 36, 37 oder Kammerwänden 23, 34, 35 angeordnet sind, können sie bei einer Veränderung der Beschichtungsprozesse, die unter Umständen eine andere Abtrennung der Gesamtanlage für Wartungsarbeiten erforderlich macht, von den Trenn- oder Kammerwänden abgenommen und an anderen Trenn- oder Kammerwänden angeordnet werden. Wesentlich ist, dass die Trennventile 5 an jeder Kammer- und/oder Trennwand angeordnet werden können, so dass jeder beliebige Teil der Beschichtungsanlage beliebig vakuumdicht abgeschlossen werden kann.

Durch die nachfolgend beschriebene Ausgestaltung eines bevorzugten Trennventils 5 ist es vorzugsweise auch möglich, die Trennventile in Transportrichtung des Substrats vor oder hinter der Kammer- bzw. Kompartmentwand anzuordnen, wobei zudem gewährleistet ist, dass die Dichtrichtung in jeder der beiden Dichtrichtungen möglich ist, dass also sowohl auf der einen als auch auf der anderen Seite des Trennventils 5 Atmosphären- oder Vakuumbedingungen herrschen können.

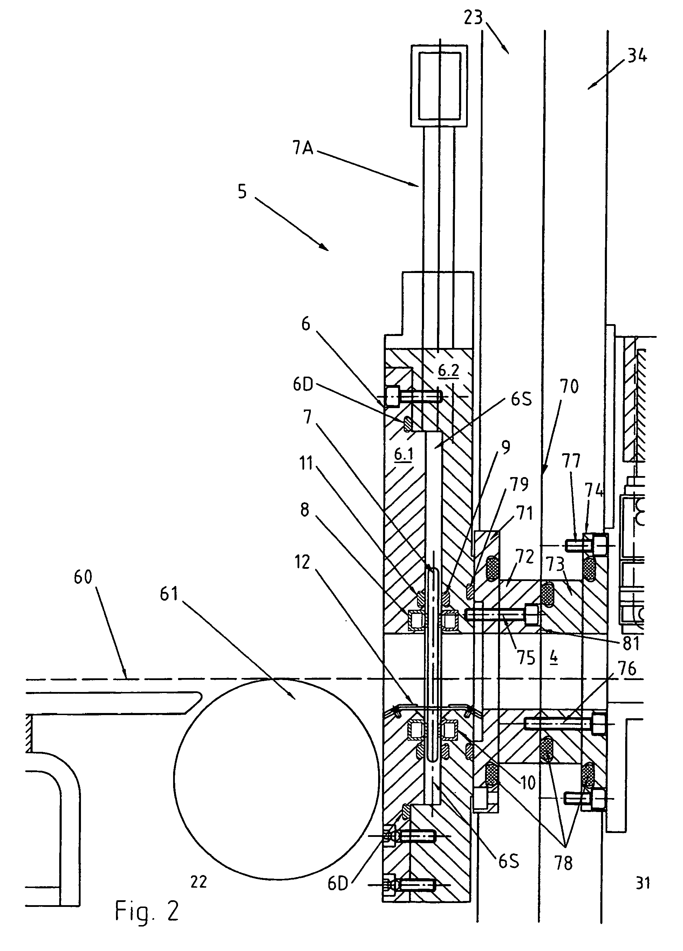

Die Fig. 2 zeigt in einer vergrößerten Darstellung eine Querschnittsansicht am Übergang vom Kompartment 22 zum Kompartment 31 mit der Durchgangsöffnung 4, die senkrecht zur Zeichnungsebene deutlich größere Abmessungen haben kann als in ihrer hier sichtbaren Höhe, also als schlitzförmig betrachtet werden kann, jedoch insgesamt mit möglichst kleinem freiem Querschnitt ausgeführt wird. Sie muss im bevorzugten Anwendungsfall gerade groß genug sein, um ebene Glasplatten von mehr als 3 m Breite durchlaufen zu lassen.

Erkennbar sind die beiden Kammern im Bereich der Öffnung 4 sehr fest und dicht miteinander verbunden, um jegliche Nebenstrombildung zu vermeiden, wenn diese Öffnung 4 mithilfe des nun zu beschreibenden Schieberventils verschlossen ist und z. B. im Modul 31 ein Vakuum herrscht, während das Modul 22 belüftet wird.

Das Schieberventil 5 umfasst zunächst ein Gehäuse 6 mit zwei Gehäuseteilen 6.1 und 6.2. Es versteht sich, dass dieses Gehäuse 6 in sich sehr gut abgedichtet ist, so weit es aus verschiedenen Bauteilen zusammengesetzt ist. Man erkennt hier z. B. einen Dichtring 6D in der Fuge zwischen den beiden Gehäuseteilen 6.1 und 6.2, und einen weiteren Dichtring 79 in der Fuge zwischen dem Gehäuseteil 6.2 und der Wand der Halterung 70, auf die das Gehäuse 6 insgesamt im Bereich der Öffnung 4 aufgespannt ist.

Das Gehäuse 6 ist insgesamt ebenfalls von der Öffnung 4 durchdrungen bzw. es hat einen Kanal, der eine Fortsetzung der besagten Öffnung 4 mit gleich bleibendem freiem Querschnitt bildet.

Man erkennt, dass im Gegensatz zum einleitend genannten Stand der Technik dieses Schieberventil nicht zwischen den beiden Modulen 22 und 31 angeordnet sein muss, sondern dass sein Gehäuse 6 einseitig an der Innenseite des Moduls 22 angeordnet ist.

Die beiden Gehäuseteile 6.1 und 6.2 bilden zwischen sich einen Führungsschlitz 6S, in dem eine Schieberplatte 7 pendelnd, d. h. in der Normalenrichtung zu ihren Hauptflächen gesehen mit geringem seitlichem Spiel gelagert ist. Sie hängt an einem nicht näher dargestellten translatorischen Stellantrieb 7A.

Dessen hier nicht näher gezeigtes Stellglied ist mit der Schieberplatte 7 in geeigneter Weise verbunden, um deren seitliche Auslenkungen zu ermöglichen. Diese Verbindung zwischen dem Stellantrieb 7A und der Schieberplatte 7 durchdringt das Gehäuse 6.

Der (senkrechte) Führungsschlitz 6S erstreckt sich, ebenso wie die in ihm aufgenommene Schieberplatte, quer zur (waagerechten) Durchgangsvorrichtung der Öffnung 4, und zwar abschnittweise beidseits der Transportebene 60. Sein wesentlicher Längenanteil befindet sich oberhalb der Transportebene 60, jedoch ist auch unterhalb ein kurzer Abschnitt vorgesehen.

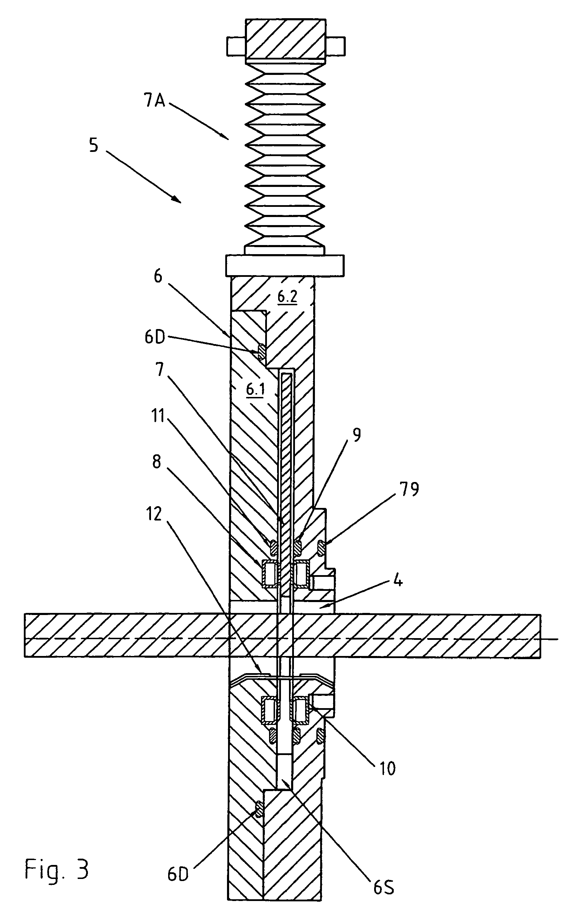

Innerhalb des Führungsschlitzes 6S ist die Schieberplatte 7 mithilfe des Stellantriebs 7A hin und her stellbar, und zwar zwischen einer Ruhestellung (vgl. Fig. 3), in der die Öffnung 4 vollständig geöffnet ist und Substrate sie durchlaufen können, und der hier gezeigten Arbeits- oder Schließstellung, in der die Schieberplatte 7 die schlitzförmige Öffnung 4 vollständig abdeckt.

In der Ruhestellung ist die Schieberplatte 7 vollständig im oberen Teil des Führungsschlitzes 6S aufgenommen, in der Arbeitsstellung taucht ihre Unterkante klingenartig in den unteren Abschnitt des Führungsschlitzes 6S ein, während ihr oberer Teil noch in dessen oberem Abschnitt verbleibt. Es ist wesentlich, dass die Schieberplatte 7 überall den Rand der Öffnung 4 überdeckt.

Die Hin- und Her-Bewegung der Schieberplatte 7 mittels des Stellantriebs 7A erfolgt zunächst frei, ohne allzu enge Führung im Führungsschlitz 6S, d. h. auch mit vernachlässigbarer Reibung. Folglich muss der Stellantrieb 7A keine allzu hohen Stellkräfte aufbringen. Er kann beispielsweise ein pneumatischer oder hydraulischer Hubzylinder sein, ein Zahnstangenantrieb, oder ein elektromagnetischer Linearmotor. Er muss keinen langen Hub ausführen (einige Zentimeter) und muss auch die Dichtplatte nur relativ grob in ihrer Arbeitsstellung positionieren können.

Die Verbindung des Stellantriebs mit der Schieberplatte bedarf jedenfalls, wie schon erwähnt, einer gewissen Elastizität oder Gelenkigkeit, da die Schieberplatte 7, wie nun beschrieben wird, auch senkrecht zur Stellrichtung des Linearantriebs 7A verschiebbar sein muss, wenn auch nur um geringe Hübe. Man kann hier z. B. am Ende des Stellglieds des Stellantriebs 7A eine Gabel vorsehen, deren beide Schenkel mittels einer, zweier oder mehr Achsen verbunden sind, an denen die Schieberplatte 7 in der erforderlichen Weise beweglich aufgehängt ist.

Es sei angemerkt, dass der Stellantrieb 7A stellvertretend für eine Mehrzahl von gleichartigen, synchron steuerbaren Stellantrieben steht, die bei Bedarf einzusetzen sind, wenn die Schieberplatte 7 sich ggf. über mehrere Meter Länge senkrecht zur Zeichnungsebene ersteckt.

In die linke Gehäusehälfte 6.1 ist ein erster Schließantrieb 8 eingelassen. Er ist vorzugsweise als aufblasbare Dichtung ausgeführt, die in eine umlaufende Ringnut der Gehäusewand eingelegt ist und ihrerseits den gesamten Umfang der Öffnung 4 umgibt. Funktional korrespondiert mit diesem Schließantrieb 8 eine Ringdichtung 9, die in die Wand der gegenüberliegenden Gehäusehälfte 6.2 ebenfalls in eine Ringnut eingelassen ist und ebenfalls die Öffnung 4 vollständig umgibt.

Exakt gegenüber (bezüglich der Mittelebene des Führungsschlitzes 6S und der Schieberplatte 7) dem Schließantrieb 8 ist im dargestellten Ausführungsbeispiel in die gegenüber liegende Wand des Gehäuseteils 6.2 ein zweiter Schließantrieb 10 gleicher Bauart wie der Schließantrieb 8 eingelassen. Er liegt innerhalb der von der Ringdichtung 9 umschriebenen Fläche.

Mit dem Schließantrieb 10 wiederum korrespondiert funktional eine Ringdichtung 11, die in die Wand des Gehäuseteils 6.1 eingelassen ist, wiederum exakt gegenüber der Ringdichtung 9, und den Schließantrieb 8 ringförmig umgibt.

Es ist allerdings Auslegungssache, ob man die Schließantriebe 8 und 10 innerhalb oder außerhalb der von den Dichtringen 9 und 11 umschriebenen Flächen anordnet. Im letzteren Fall sind die Schließantriebe gegen Vakuumeinwirkung auf der abgeschlossenen Seite geschützt. Im ersteren Fall schützt der Schließantrieb den jeweils auf derselben Seite liegenden Dichtring vor Overspray, d. h. den ungewollten Auftrag von Beschichtungspartikeln, die aus der Vakuumkammer in die Öffnung und zu dem Ventil gelangen können.

Es ist, wie schon erwähnt, nicht zwingend erforderlich, die Schließantriebe 8 und/oder 10 als einheitliche, schlauchreifenartig umlaufende Kammern auszulegen. Es ist insbesondere auch denkbar, die Schließantriebe statt umlaufend nur als zwei parallele längliche Abschnitte beidseits der Öffnung 4 auszuführen. Auch damit wäre noch ein wesentlicher Schutz der Dichtringe gegen Overspray gewährleistet.

Man könnte ferner eine Anzahl von Einzelkammern gleichmäßig über den Umfang der Dichtflächen verteilen, die natürlich alle fluidisch miteinander kommunizieren und synchron mit Druck beaufschlagt werden müssen.

Es liegt im Rahmen der Erfindung, dass nur einer der Schließantriebe vorgesehen sein kann, wenn nur in einer Richtung die Schieberplatte dichtend auszulegen ist.

Die hier erörterte umlaufende Konfiguration der Schließantriebe 8 und 10 hat allerdings den Vorteil, dass sie bei geeigneter Auslegung ihrer Außenflächen als Sekundärdichtungen auf der glatten Fläche der Schieberplatte 7 anliegen und damit die Dichtwirkung der Dichtringe 9 bzw. 11 noch unterstützen, solange ihr Innenraum mit Druck beaufschlagt ist.

Unterhalb der Transportebene 60 ist im Bereich der Öffnung 4 und des Führungsschlitzes 6S in dem Gehäuse ein Streifen 12 aus dauerelastischem Material austauschbar befestigt. Er verschließt den unterhalb der Transportebene liegenden Abschnitt des Führungsschlitzes 6S und verhindert das Hinabfallen von Partikeln in den unteren Abschnitt des Führungsschlitzes 6S. Er ist als Lippendichtung geteilt ausgeführt und lässt die Schieberplatte 7 ungehindert eintauchen, wenn diese in ihre Arbeitsstellung gebracht wird.

Es versteht sich, dass die Dichtringe 9 und 11 sowie die Schließantriebe 8 und 10 jeweils so weit in die jeweiligen Gehäusewände eingelassen sind bzw. ggf. durch Unterdruckbeaufschlagung darin einziehbar sind, dass Beschädigungen oder auch nur Reibung durch Kontakte mit der Schieberplatte 7 während deren Umstellbewegung zwischen Ruhe- und Arbeitsstellung ausgeschlossen werden können.

Zugleich ist natürlich durch geeignete Sicherungsmaßnahmen auszuschließen, dass der Stellantrieb 7A aktiviert wird, während einer der Schließantriebe 8 und 10 mit Druck beaufschlagt ist. Eine rein manuelle Betätigung der Schieberplatte 7 im aktivierten Zustand eines der Schließantriebe 8 oder 10 dürfte ohnehin wegen der hohen Anpresskräfte unmöglich sein.

Man erkennt, dass die Schieberplatte 7 im Vergleich mit den Dicken der Gehäuseteile 6.1 und 6.2 recht dünn und leicht gehalten werden kann. Im Zusammenwirken mit einer möglichst gleichmäßigen Verteilung der von den Schließantrieben 8 bzw. 10 her einwirkenden Schließkräfte wird sich die Schieberplatte 7 folglich exakt dem Verlauf der Dichtringe 9 bzw. 11 anschmiegen können, selbst wenn diese geringfügige langwellige Abweichungen aus der ideellen Dichtebene aufweisen sollten.

Im Regelfall wird die Schieberplatte 7 von dem Antrieb 7A dann betätigt, wenn der Druck in beiden voneinander abzutrennenden Modulen (noch oder wieder) gleich ist, also z. B. beidseitig Atmosphärendruck oder beidseitig Vakuum anliegt.

Ist ihre Arbeitsstellung erreicht (ihre Unterkante liegt eingetaucht im unteren Teil des Führungsschlitzes 6S), so wird je nach der Richtung der über die Schieberplatte 7 abzuschlie-ßenden (noch aufzubauenden) Druckdifferenz (z. B. Vakuum im Modul 31, Atmosphärendruck im Modul 22 oder umgekehrt) einer der Schließantriebe 8 oder 10 mit Innendruck gespeist/beaufschlagt, wobei vorzugsweise der vom geringeren Druckniveau abgewandt angeordnete Schließantrieb aktiviert wird.

Soll z. B. in der Schließstellung des Schieberventils 5 Vakuum im Modul 31 anliegen, so wird der (linke) Schließantrieb 8 aktiviert. Durch das resultierende Aufblasen seines Schlauchquerschnitts wird die Schieberplatte 7 insgesamt gegen die (rechte) Ringdichtung 9 gepresst.

Soll hingegen in der Schließstellung des Schieberventils 5 der Druck im Modul 22 kleiner als der im Modul 31 werden, so wird man den (rechten) Schließantrieb 10 aktivieren, um die Schieberplatte 7 gegen die (linke) Ringdichtung 11 zu drücken.

Durch diese Maßnahmen wird die Belastung des flexiblen Mantels der Schließantriebe 8 bzw. 10 mit übermäßigen Druckdifferenzen (Innendruck gegen Vakuum) vermieden.

Offensichtlich wird die Anpresskraft der Schließantriebe 8 bzw. 10 mit wachsendem Aufbau einer Druckdifferenz zwischen den Modulen 22 und 31 noch unterstützt, da der höhere Druck auf der einen Seite die Schieberplatte 7 noch stärker auf die Ringdichtung 9 bzw. 11 drückt.

Man versteht ferner, dass die Schließantriebe 8 und 10 die eigentlichen Ventilantriebe sind, welche die Dichtungsfunktion sicherstellen. Der Stellantrieb 7A ist lediglich zum Positionieren der Schieberplatte in ihre generelle Arbeitsstellung vorgesehen, unabhängig von der Richtung der Druckdifferenz. Hierdurch kann die eigentliche Dichtfunktion des Schieberventils 5 bzw. der einstückigen Schieberplatte 7 hier in beiden Richtungen genutzt werden, indem wahlweise einer der Schließantriebe 8 oder 10 betätigt wird.

Man erkennt, dass das hier beschriebene und gezeigte Ausführungsbeispiel des Schieberventils 5 in seinen Teilen mit Dichtungsfunktion spiegelsymmetrisch aufgebaut ist und deshalb in beide Richtungen eine hohe Druckdifferenz über die Ebene der Schieberplatte 7 ertragen kann. Es ist jedoch denkbar, es auch nur für eine Dichtrichtung auszulegen, wobei entweder der Schließantrieb 8 und die Ringdichtung 10 oder der Schließantrieb 9 und die Ringdichtung 11 wegfallen könnten.

Nach Abbau der vom Schieberventil 5 abzuschließenden Druckdifferenz, ggf. auch nach aktivem Zurückziehen des zuvor aktivierten Schließantriebs 8 oder 10, kann der Stellantrieb 7A die Schieberplatte wieder in ihre Ruhestellung überführen. Ggf. kann das Lösen der Schieberplatte 7 von den Dichtringen 9 oder 11 mittels hier nicht dargestellter Blatt- oder Tellerfedern unterstützt werden, deren Rückstellkraft natürlich von den Schließantrieben überwunden werden muss.

In Fig. 2 ist in der Querschnittsansicht auch die Halterung 70 dargestellt, mit der das Trenn- bzw. Schiebeventil 5 mit seinem Gehäuse 6 an den Kammerwänden 23 und 34 der benachbarten Kompartments 22 und 31 angeordnet ist.

Die Halterung 70 umfasst eine erste Stufenplatte 71, 72, die in Durchgangsrichtung der Substrate zwei unterschiedliche Bereiche 71 und 72 mit unterschiedlichen Längen- und Breitendimensionen aufweist, so dass die erste Stufenplatte 71, 72 in die Öffnung 4 und eine stufenartige Ausnehmung der Kammerwand 23 eingesetzt werden kann. Hierbei wird eine umlaufend um die Schlitzöffnung 4 vorgesehene Dichtung 78 im Bereich der Stufen an die Kammerwand 23 zur Anlage gebracht, um in radialer Richtung eine Abdichtung der ersten Stufeplatte 71, 72 gegenüber der Kammerwand 23 zu erzielen. Die erste Stufenplatte 71, 72 kann, wie hier dargestellt, einteilig oder auch zweiteilig mit getrennten Bereichen 71 und 72 ausgeführt sein.

Die erste Stufenplatte 71, 72 ist über eine Schraubverbindung 75, die mehrere Schrauben umlaufend um die Öffnung 4 umfassen kann, mit dem Gehäuse 6 des Trenn- bzw. Schieberventils 5 verbunden. An einer gemeinsamen Anschlagfläche zwischen erster Stufenplatte 71, 72 und Gehäuse 6, insbesondere Gehäuseteil 6.2, ist ebenfalls eine um die Öffnung umlaufende Dichtung 79 vorgesehen, so dass auch eine in radialer Richtung vakuumdichte Verbindung zwischen dem Gehäuse 6 und der ersten Stufenplatte 71, 72 vorgesehen ist.

Neben der ersten Stufenplatte 71, 72 ist eine zweite Stufenplatte 73, 74 vorgesehen, die ebenfalls eine stufenartige Ausbildung spiegelsymmetrisch zur ersten Stufenplatte 71, 72 aufweist und in eine entsprechende stufenartige Ausnehmung der Kammerwand 34 eingreift. An der Anschlag- oder Dichtfläche 81, an der sich erste und zweite Stufenplatten berühren, ist ebenfalls eine um die Öffnung 4 umlaufende Dichtung 78 vorgesehen, so dass auch in radialer Richtung eine vakuumdichte Verbindung zwischen erster 71, 72 und zweiter 73, 74 Stufenplatten vorhanden ist. Die zweite Stufenplatte 73, 74, die ebenfalls zweiteilig mit den Bereichen 73 und 74 ausgeführt sein kann, ist über eine Schraubverbindung, die ebenfalls vorzugsweise mehrere umlaufend um die Öffnung vorgesehene Schrauben 76 aufweist, mit der ersten Stufenplatte 71, 72 verbunden und zusätzlich über die Schraubverbindung 77, die ebenfalls wieder umlaufend um die Öffnung mehrere Schrauben aufweisen kann, mit der Kammerwand 34 verbunden, so dass über die Schraubverbindung 76 die Halterung 70 in der Öffnung 4 klammernd die Randbereiche der Kammerwände 23 und 34 umgreift, um so die Halterung und das Trennventil 5 vakuumdicht an den Kammerwänden 23 und 34 anzuordnen.

Bei geschlossener Ventilstellung, also in der Stellung der Schieberplatte 7 der Fig. 2 kann somit in jedem Fall eine gasdichte Abtrennung zwischen den Kompartments 22 und 31 hergestellt werden, wobei die Dichtrichtung frei wählbar ist, so dass sowohl auf der einen als auch auf der anderen Seite des Trennventils 5 Atmosphären- oder Vakuumbedingungen vorliegen können.

Durch die flache Ausbildung des Trennventils 5 kann das Trennventil 5 unabhängig von der Transporteinrichtung 60 bzw. 61 an den Kammerwänden 23 und 34 angeordnet werden, d.h. eine Veränderung der Transporteinrichtung ist nicht erforderlich.

Außerdem kann das Trennventil 5 bei Bedarf in einfacher Weise durch Lösen der Schraubverbindungen 77, 76 und gegebenenfalls 75 leicht entfernt und auch wieder angebaut werden. Damit ist ein variabler Einsatz der Trennventile in allen Bereichen der Anlage möglich.

## Patentansprüche

1. Vakuumbehandlungsanlage, insbesondere zum kontinuierlichen Beschichten durchlaufender Substrate, vorzugsweise Glasbeschichtungsanlage, mit mindestens zwei, vorzugsweise mehreren nebeneinander angeordneten Kammern (20, 30) oder Kammerbereichen (21, 22, 31, 32, 33), die mittels einer oder mehrerer Kammer- (23, 34, 35) und/oder Trennwände (24, 36, 37) voneinander getrennt und über Öffnungen (4) in der/den Kammer- und/oder Trennwänden, vorzugsweise Schlitzschleusen zum Durchführen der Substrate miteinander verbunden sind, wobei mindestens eine Öffnung durch eine Ventileinrichtung (5) zum vakuumdichten Abtrennen von Kammern und/oder Kammerbereichen vakuumdicht verschließbar ist, **dadurch gekennzeichnet, dass** die Ventileinrichtung lösbar in der Kammer, insbesondere an der Innenseite der Kammer- und/oder Trennwand, befestigt ist, wobei bei der Anbringung oder Entfernung der Ventileinrichtung keine Änderung der Lage der Kammern zueinander erforderlich ist.

2. Vakuumbehandlungsanlage nach Anspruch 1, **dadurch gekennzeichnet, dass** die Ventileinrichtung (5) so an der Kammer- oder Trennwand befestigt ist, dass das Befestigen und/oder Abnehmen ohne Veränderung der Kammer- oder Trennwand durchführbar ist.

3. Vakuumbehandlungsanlage nach Anspruch 1 oder 2, **dadurch gekennzeichnet, dass** die Ventileinrichtung (5) einerseits und die Kammer mit den darin angeordneten Prozesswerkzeugen und Transporteinrichtungen für die Substrate andererseits so aufeinander abgestimmt sind, dass die Anordnung oder Entfernung der Ventileinrichtung an der Kammer- oder Trennwand ohne Abänderung der Kammer und/oder ohne Veränderung der Anordnung der Prozesswerkzeuge und/oder der Transporteinrichtung in der Kammer zumindest im nach dem Ein- oder Abbau wieder hergestellten Betriebszustand und/oder ohne Änderung der Lage der Kammern zueinander erfolgen kann.

4. Vakuumbehandlungsanlage nach einem der vorhergehenden Ansprüche, **dadurch gekennzeichnet, dass** die Ventileinrichtung (5) ein Gehäuse (6) und eine darin bewegliche Ventilklappe (7) zum vakuumdichten Verschließen der Öffnung (4) umfasst, wobei das Gehäuse bei geschlossener Ventilklappe vakuumdicht und lösbar an der Kammer- oder Trennwand befestigt ist.

5. Vakuumbehandlungsanlage nach einem der vorhergehenden Ansprüche, **dadurch gekennzeichnet, dass** die Ventileinrichtung (5) an der Öffnung (4) über eine Halterung (70) lösbar befestigt ist, wobei insbesondere die Halterung als Klammer ausgeführt ist, die die benachbarten Kammerwände oder eine einzelne Trennwand entlang des Umfangs der Öffnung vakuumdicht umgreift.

6. Vakuumbehandlungsanlage nach Anspruch 5, **dadurch gekennzeichnet, dass** die Ventileinrichtung (5) vakuumdicht an der Halterung (70) angeordnet, insbesondere lösbar befestigt ist.

7. Vakuumbehandlungsanlage nach Anspruch 5 oder 6, **dadurch gekennzeichnet, dass** die Halterung (70) eine erste (71, 72) und eine zweite (73, 74) jeweils mit einer zentralen, schlitzfömigen Öffnung versehene, insbesondere in Durchgangsrichtung zweiteilige Stufenplatte umfasst, die in Durchgangsrichtung zwei die Stufe bildende Bereiche mit unterschiedlicher Länge und/oder Breite aufweist, wobei die erste Stufenplatte mit dem Gehäuse (6) der Ventileinrichtung (5) und die zweite Stufenplatte mit der Kammer- oder Trennwand, insbesondere der der Ventileinrichtung abgewandten Kammerwand (34) der benachbarten Kammer, und die Stufenplatten untereinander lösbar verbunden sind und Anschlagflächen zwischen Ventilgehäuse und erster Stufenplatte sowie zweiter Stufenplatte und Kammer- oder Trennwand und zwischen den Stufenplatten vorgesehen sind, in denen Dichtmittel aufgenommen sind.

8. Vakuumbehandlungsanlage nach Anspruch 7, **dadurch gekennzeichnet, dass** die Kammerwand (23, 34) an der Innenseite eine stufenartige Ausnehmung oder die Trennwand beidseitig stufenartige Ausnehmungen aufweisen, in die die Stufenplatten eingreifen.

9. Vakuumbehandlungsanlage nach einem der vorhergehenden Ansprüche, **dadurch gekennzeichnet, dass** die lösbaren Verbindungen Schraubverbindungen (75, 76, 77) sind.

10. Vakuumbehandlungsanlage nach einem der vorhergehenden Ansprüche, **dadurch gekennzeichnet, dass** die Ventileinrichtung ein Schieber- (5) oder Klappenventil ist.

11. Vakuumbehandlungsanlage nach einem der vorhergehenden Ansprüche, **dadurch gekennzeichnet, dass** die Ventileinrichtung (5) die Öffnung (4) in beide Dichtrichtungen und somit unabhängig von Atmosphären- und Vakuumseite verschließen kann.

12. Vakuumbehandlungsanlage nach einem der vorhergehenden Ansprüche, **dadurch gekennzeichnet, dass** die Ventileinrichtung (5) ein zweiteiliges Gehäuse (6) aufweist, wobei die Gehäuseteile (6.1, 6.2) von der im Gehäuse vorgesehenen Durchgangsöffnung aus in radialer Richtung vakuumdicht miteinander verbunden sind und zwischen sich einen Führungsschlitz (6S) für eine verschiebbare Ventilklappe (7) bilden, wobei die verschiebbare Ventilklappe zwischen einer die Durchgangsöffnung verschließende und einer die Durchgangsöffnung frei gebende Stellung verschiebbar ist und mittels eines, vorzugsweise von zwei symmetrisch zum Führungsschlitz vorgesehenen Stellantrieben (8, 10) in Durchgangsrichtung gegen mindestens eine, vorzugsweise zwei, vorzugsweise mit Dichtmitteln (9, 11) versehene Dichtfläche gedrückt werden kann, wobei die Stellantriebe durch Fluiddruck aktivierbar sind und insbesondere über ein elastisch bewegliches Element wirken.

## Claims

1. Vacuum treatment apparatus, particularly for continuous coating of continuous substrates, preferably a glass coating apparatus, with at least two and preferably several chambers (20, 30) or chamber zones (21, 22, 31, 32, 33) arranged side by side which are separated from each other by one or more chamber walls (23, 34, 35) and/or partition walls (24, 36, 37) and intercommunicate via openings (4) in the chamber walls and/or partition walls, preferably slit gates through which the substrates are led, at least one opening being closable in a vacuum tight fashion by a valve device (5) for a vacuum tight partitioning-off of chambers and/or chamber zones, **characterized in that** the valve device is detachably mounted in the chamber, in particular on the inside of the chamber wall and/or partition wall, in such a way that the installation or removal of the valve device does not necessitate any alteration to the position of the chambers relative to each other.

2. Vacuum treatment apparatus according to Claim 1, **characterized in that** the valve device (5) is mounted on the chamber wall or partition wall in such a way that mounting and/or removal can be carried out without altering the chamber wall or partition wall.

3. Vacuum treatment apparatus according to Claim 1 or Claim 2, **characterized in that** the valve device (5) on the one hand and the chamber with the process tools and transport apparatus for the substrates arranged within it on the other hand are coordinated so that the mounting of the valve device on the chamber wall or partition wall, or its removal there from, can be performed without modification of the chamber, and/or without alteration to the arrangement of the process tools and/or transport apparatus inside the chamber at least in the operating condition restored after the installation or removal, and/or without alteration to the position of the chambers relative to each other.

4. Vacuum treatment apparatus according to any one of the preceding claims, **characterized in that** the valve device (5) comprises a casing (6) and a valve shutter (7) movable therein for vacuum tight closure of the opening (4), the casing being mounted on the chamber wall or partition wall detachably, yet in a vacuum tight fashion when the valve shutter is closed.

5. Vacuum treatment apparatus according to any one of the preceding claims, **characterized in that** the valve device (5) is detachably mounted at the opening (4) by a mounting bracket (70), the mounting bracket being configured in particular as a clamp gripping the adjacent chamber walls, or a single partition wall, along the perimeter of the opening, in a vacuum tight fashion.

6. Vacuum treatment apparatus according to Claim 5, **characterized in that** the valve device (5) is arranged, and in particular detachably mounted, in a vacuum tight fashion on the mounting bracket (70).

7. Vacuum treatment apparatus according to Claim 5 or Claim 6, **characterized in that** the mounting bracket (70) comprises first (71, 72) and second (73, 74) step plates which are each provided with a central slit-shaped opening and are in particular made in two pieces in the run-through direction and have two regions of different length and/or width forming the step in the run-through direction, the first step plate being releasably connected to the casing (6) of the valve device (5), the second step plate being releasably connected to the chamber wall or partition wall and in particular to the wall (34) of the adjacent chamber facing away from the valve device, and the step plates themselves being releasably connected to one another, abutment faces in which sealing means are seated being provided between the valve casing and the first step plate, between the second step plate and the chamber wall or partition wall, and between the step plates themselves.

8. Vacuum treatment apparatus according to Claim 7, **characterized in that** the chamber walls (23, 24) each have a stepped recess on the inside, or the partition wall has stepped recesses on both sides, into which the step plates engage.

9. Vacuum treatment apparatus according to any one of the preceding claims, **characterized in that** the releasable connections are screw connections (75, 76, 77).

10. Vacuum treatment apparatus according to any one of the preceding claims, **characterized in that** the valve device is a slide gate valve (5) or flap valve.

11. Vacuum treatment apparatus according to any one of the preceding claims, **characterized in that** the valve device (5) is capable of shutting the opening (4) in both sealing directions and hence regardless of which is the atmosphere side and which the vacuum side.

12. Vacuum treatment apparatus according to any one of the preceding claims, **characterized in that** the valve device (5) has a two-piece casing (6), the casing pieces (6.1, 6.2) being connected to each other in a vacuum tight fashion in the direction radially outwards from the through opening provided in the casing, and forming between them a guide slit (6S) for a displaceable valve shutter (7), the displaceable valve shutter being displaceable between a position shutting the through opening and a position uncovering the through opening and pressable in the run-through direction against at least one and preferably two sealing faces preferably provided with sealing means (9, 11), by two actuators (8, 10) provided symmetrically with respect to the guide slit, the actuators being activatable by fluid pressure and in particular acting through an elastically movable element.

## Revendications

1. Installation de traitement sous vide, destinée en particulier au revêtement en continu de substrats continus, de préférence installation de revêtement de verre, comprenant au moins deux, de préférence plusieurs chambres (20, 30) ou zones de chambre (21, 22, 31, 32, 33) disposées les unes à côté des autres, qui sont séparées les unes des autres par une ou plusieurs parois de chambre (23, 34, 35) et/ou parois de séparation (24, 36, 37) et qui sont reliées les unes aux autres par l'intermédiaire d'ouvertures (4) situées dans les parois de chambre et/ou les parois de séparation, de préférence des vannes à fente pour faire passer les substrats, dans laquelle au moins une ouverture peut être fermée de manière étanche au vide par l'intermédiaire d'un dispositif de vanne (5) pour séparer de manière étanche au vide des chambres et/ou des zones de chambre, **caractérisée en ce que** le dispositif de vanne est fixé de manière amovible dans la chambre, en particulier au niveau de la paroi interne de la paroi de chambre et/ou de la paroi de séparation, la mise en place ou le retrait du dispositif de vanne ne nécessitant pas de modification de la position des chambres les unes par rapport aux autres.

2. Installation de traitement sous vide selon la revendication 1, **caractérisée en ce que** le dispositif de vanne (5) est fixé sur la paroi de chambre ou la paroi de séparation de telle sorte que la fixation et/ou le retrait peuvent être réalisés sans modification de la paroi de chambre ou de la paroi de séparation.

3. Installation de traitement sous vide selon la revendication 1 ou 2, **caractérisée en ce que** le dispositif de vanne (5), d'une part, et la chambre dans laquelle se trouvent les outils de procédé et les dispositifs de transport pour les substrats, d'autre part, sont adaptés l'un à l'autre de sorte que la mise en place ou le retrait du dispositif de vanne au niveau de la paroi de chambre ou de la paroi de séparation peuvent être réalisés sans modification de la chambre et/ou sans modification de la disposition des outils de procédé et/ou du dispositif de transport dans la chambre, au moins à l'état de fonctionnement rétabli après le montage ou le démontage et/ou sans modification de la position des chambres les unes par rapport aux autres.

4. Installation de traitement sous vide selon l'une quelconque des revendications précédentes, **caractérisée en ce que** le dispositif de vanne (5) comprend un logement (6) et un clapet de vanne (7) mobile dans celui-ci pour fermer de manière étanche au vide de l'ouverture (4), dans laquelle le logement est fixé de manière étanche au vide lorsque le clapet de vanne est fermé et de manière amovible sur la paroi de chambre ou sur la paroi de séparation.

5. Installation de traitement sous vide selon l'une quelconque des revendications précédentes, **caractérisée en ce que** le dispositif de vanne (5) est fixé de manière amovible au niveau de l'ouverture (4) par l'intermédiaire d'une fixation (70), dans laquelle en particulier la fixation est réalisée sous forme de bride qui entoure de manière étanche au vide les parois de chambres adjacentes ou une seule paroi de séparation sur la circonférence de l'ouverture.

6. Installation de traitement sous vide selon la revendication 5, **caractérisée en ce que** le dispositif de vanne (5) est disposé sur la fixation (70) de manière étanche au vide, en particulier de manière amovible.

7. Installation de traitement sous vide selon la revendication 5 ou 6, **caractérisée en ce que** la fixation (70) comprend une première (71, 72) et une deuxième (73, 74) plaques à gradin, en particulier en deux parties dans le sens de passage, chacune pourvues d'une ouverture centrale en forme de fente, qui présentent, dans le sens de passage, deux zones formant le gradin ayant une longueur et/ou une largeur différentes, dans laquelle la première plaque à gradin est reliée de manière amovible au logement (6) du dispositif de vanne (5) et la deuxième plaque à gradin est reliée de manière amovible à la paroi de chambre ou à la paroi de séparation, en particulier à la paroi de chambre (34) de la chambre adjacente opposée au dispositif de vanne, et les plaques à gradin sont reliées les unes aux autres de manière amovible, et dans laquelle des surfaces d'arrêt contenant des garnitures d'étanchéité sont prévues entre le logement de vanne et la première plaque à gradin ainsi qu'entre la deuxième plaque à gradin et la paroi de chambre ou de la paroi de séparation et entre les plaques à gradin.

8. Installation de traitement sous vide selon la revendication 7, **caractérisée en ce que** la paroi de chambre (23, 34) présente un évidement en forme de gradin au niveau de la face interne, ou la paroi de séparation présente de part et d'autre des évidements en forme de gradin dans lesquels s'engagent les plaques à gradin.

9. Installation de traitement sous vide selon l'une quelconque des revendications précédentes, **caractérisée en ce que** les raccordements amovibles sont des raccordements par filetage (75, 76, 77).

10. Installation de traitement sous vide selon l'une quelconque des revendications précédentes, **caractérisée en ce que** le dispositif de vanne est une vanne à tiroir (5) ou une vanne à clapet.

11. Installation de traitement sous vide selon l'une quelconque des revendications précédentes, **caractérisée en ce que** le dispositif de vanne (5) est capable de fermer l'ouverture (4) dans les deux sens d'étanchement et donc indépendamment du côté de l'atmosphère et du côté du vide.

12. Installation de traitement sous vide selon l'une quelconque des revendications précédentes, **caractérisée en ce que** le dispositif de vanne (5) présente un logement en deux parties (6), dans lequel les parties de logement (6.1, 6.2) sont reliées l'une à l'autre de manière étanche au vide dans le sens radial par rapport à l'ouverture de passage prévue dans le logement et forment entre elles une fente de guidage (6S) pour un clapet de vanne coulissant (7), le clapet de vanne coulissant pouvant coulisser entre une position fermant l'ouverture de passage et une position libérant l'ouverture de passage et pouvant être pressé contre au moins une, de préférence deux surfaces d'étanchéité, pourvues de préférence de garnitures d'étanchéité (9, 11) au moyen d'un, de préférence deux vérins (8, 10) disposés dans le sens de passage symétriquement à la fente de guidage, les vérins pouvant être activés au moyen d'une pression hydraulique et fonctionnent en particulier par l'intermédiaire d'un élément mobile de manière élastique.
